# EUROPEAN PATENT APPLICATION

(11) **EP 2 426 137 A1**
(43) Date of publication of application: **07.03.2012**
(21) Application number: 11156961.2
(22) Date of filing: 04.03.2011
(51) Int. Cl.: C07F 9/50, C09K 11/06, H01L 51/50

(54) **Novel compound and organic light-emitting diode, display and illuminating device using the same**

(30) Priority: 07.09.2010 JP 2010200210
(71) Applicant: Kabushiki Kaisha Toshiba, Tokyo 105-8001 (JP)
(72) Inventor: Wada, Atsushi, 1-1, Shibaura 1-chome, Minato-ku Tokyo 105-8001 (JP); Takasu, Isao, 1-1, Shibaura 1-chome, Minato-ku Tokyo 105-8001 (JP); Mizuno, Yukitami, 1-1, Shibaura 1-chome, Minato-ku Tokyo 105-8001 (JP); Sawabe, Tomoaki, 1-1, Shibaura 1-chome, Minato-ku Tokyo 105-8001 (JP); Sugizaki, Tomoko, 1-1, Shibaura 1-chome, Minato-ku Tokyo 105-8001 (JP); Enomoto, Shintaro, 1-1, Shibaura 1-chome, Minato-ku Tokyo 105-8001 (JP)
(74) Representative: HOFFMANN EITLE

(57) **Abstract**

According to one embodiment, there is provided a compound represented by Formula (1): 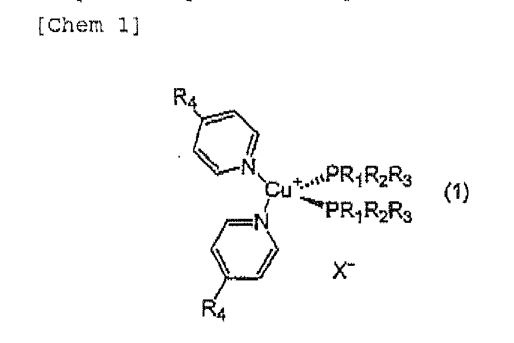 where Cu⁺ represents a copper ion, PR₁R₂R₃ is a phosphine compound coordinating with Cu⁺, where R₁, R₂ and R₃ may be the same or different, and represent a linear, branched or cyclic alkyl group having 1-6 carbon atoms or an aromatic cyclic group which may have a substituent, R₄ is an electron-donating substituent and X⁻ represents a counter ion where X is at least one selected from the group consisting of F, Cl, Br, T, BF₄, PF₆, CH₃CO₂, CF₃CO₂, CF₃SO₃ and ClO₄.

## Description

### FIELD

Embodiments described herein relate generally to a novel compound and an organic light-emitting diode, a display and an illuminating device using the same.

### BACKGROUND

In recent years, organic light-emitting diodes have been attracting attention as a technology for next-generation displays and lightings. In the early study of organic light-emitting diodes, fluorescence has been mainly used. However, in recent years, an organic light-emitting diode utilizing phosphorescence which exhibits higher internal quantum efficiency has been attracting attention.

Mainstream of emissive layers utilizing phosphorescence in recent years are those in which a host material comprising an organic material is doped with an missive metal complex including iridium or platinum as a central metal.

However, an iridium complex and platinum complex are rare metals and are therefore expensive, giving rise to the problem that organic light-emitting diodes using these rare metals are increased in cost. Copper complexes, on the other hand, likewise emit phosphorescent light and are inexpensive, so that they are expected to reduce the production cost.

An organic light-emitting diode using a copper complex as a light-emitting material has been disclosed. However, the copper complex used here has the problem that the synthetic method is complicated. Also, a material capable of blue emission with high efficiency is required for application to lighting which emits white light and a RGB (Red, Green, and Blue) full color display.

### BRIEF DESCRIPTION OF THE DRAWINGS

FIG. 1 is a cross-sectional view of an organic light-emitting diode of an embodiment;
FIG. 2 is a circuit diagram showing a display of an embodiment;
FIG. 3 is a cross-sectional view showing a lighting device of an embodiment;
FIG. 4 is a view showing the ¹H-NMR spectrum of [Cu(NMe₂-py)₂(PPh₃)₂]BF₄;
FIG. 5 is a view showing the photoluminescence spectrum of [Cu(NMe₂-py)₂(PPh₃)₂]BF₄;
FIG. 6A is a view showing the relationship between the voltage and current density of the diode according to Example;
FIG. 6B is a view showing the relationship between the voltage and luminance of the diode according to Example; and
FIG. 6C is a view showing the relationship between the voltage and luminous efficacy of the diode according to Example.

### DETAILED DESCRIPTION

In general, according to one embodiment, there is provided a compound represented by Formula (1): 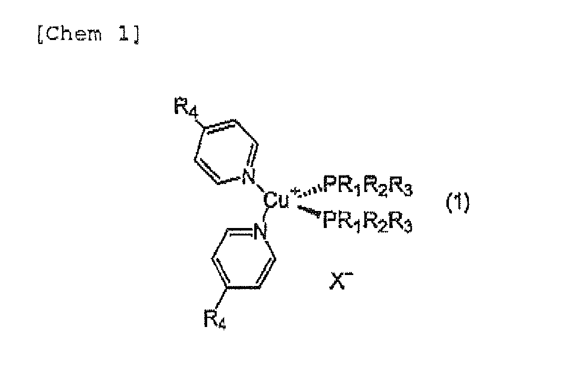 where Cu⁺ represents a copper ion, PR₁R₂R₃ represents a phosphine compound coordinating with Cu⁺, where R₁, R₂ and R₃ may be the same or different, and represent a linear, branched or cyclic alkyl group having 1-6 carbon atoms or an aromatic cyclic group which may have a substituent, R₄ represents an electron-donating substituent, and X⁻ represents a counter ion where X is at least one selected from the group consisting of F, Cl, Br, I, BF₄, PF₆, CH₃CO₂, CF₃CO₂, CF₃SO₃ and ClO₄.

Embodiments of the present invention are explained below in reference to the drawings.

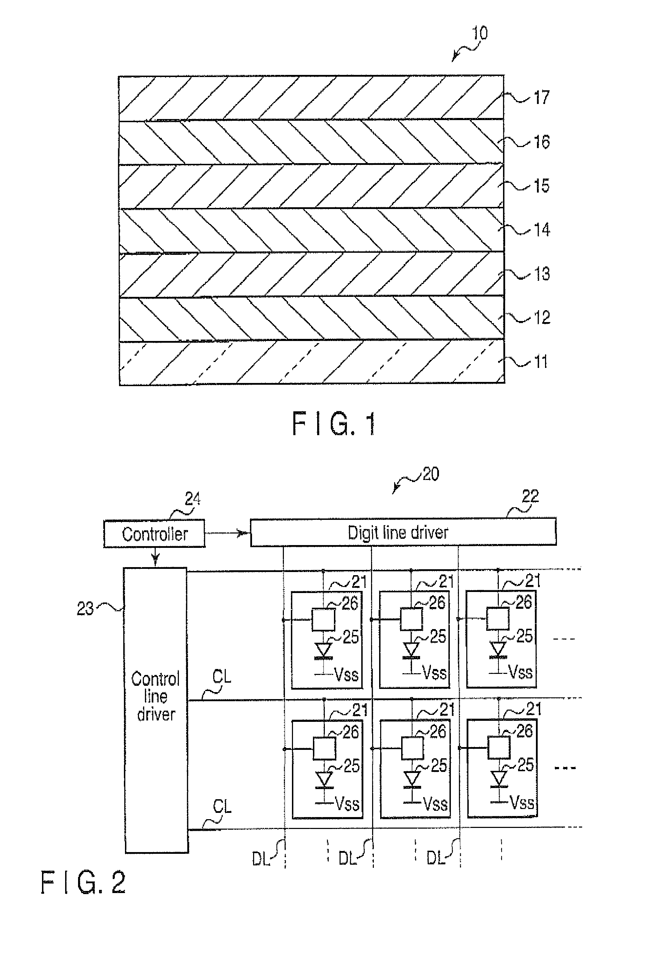

FIG. 1 is a cross-sectional view of the organic light-emitting diode of an embodiment of the present invention.

In the organic light-emitting diode 10, an anode 12, hole transport layer 13, emissive layer 14, electron transport layer 15, electron injection layer 16 and cathode 17 are formed in sequence on a substrate 11. The hole transport layer 13, electron transport layer 15 and electron injection layer 16 are formed if necessary.

Each member of the organic light-emitting diode of the embodiment of the present invention is explained below in detail.

The emissive layer 14 receives holes and electrons from the anode and the cathodes, respectively, followed by recombination of holes and electrons which results in the light emission. The energy generated by the recombination excites the host material in the emissive layer. An emitting dopant is excited by energy transfer from the excited host material to the emitting dopant, and the emitting dopant emits light when it returns to the ground state.

The emissive layer 14 contains a luminescent metal complex (hereinafter, referred to as an emitting dopant), which is doped into the host material of an organic material. In this embodiment, a copper complex represented by the following formula (1) is used as an emitting dopant.

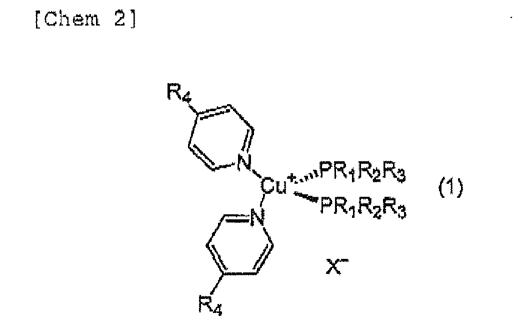

In the formula, Cu⁺ represents a copper ion. PR₁R₂R₃ represents a phosphine compound coordinating with Cu⁺. R₁, R₂ and R₃ may be the same or different, and represent a linear, branched or cyclic alkyl group having 1-6 carbon atoms or an aromatic cyclic group which may have a substituent. Specific examples of the alkyl group include a methyl group, isopropyl group and cyclohexyl group. Specific examples of the above aromatic cyclic group include a phenyl group, naphthyl group and phenoxy group. These may be substituted by a substituent such as an alkyl group, halogen atom and carboxyl group. R₄ represents an electron-donating substituent. Examples of the electron-donating group include a methyl group, amino group, dimethylamino group, methoxy group, and the like. X⁻ represents a counter ion, wherein X represents F, Cl, Br, I, BF₄, PF₆, CH₃CO₂, CF₃CO₂, CF₃SO₃ or ClO₄.

The use of the copper complex as the emitting dopant enables the fabrication of an organic light-emitting diode more reduced in cost than in the case of using an iridium complex or platinum complex. Further, the copper complex represented by the above formula (1) can be synthesized more easily than other copper complexes which are known to be used as the emitting dopant.

The copper complex represented by the above formula (1) has a shorter emission wavelength as compared to the copper complexes which are known to be used as the emitting dopant. Therefore, with the use of the copper complexes of the above formula (1) as the emitting dopant, it is possible to attain emission closer to blue.

Also, even in the case where the copper complex represented by the above formula (1) is used as the emitting dopant, it is possible to provide an organic light-emitting diode having emission efficacy and luminance which are greater them or equal to the conventional organic light-emitting diode.

Hereinafter, a synthetic scheme of the copper complex represented by the above formula (1) will be described. In the following reaction formulas, R₁, R₂, R₃, R₄ and X are as defined above.

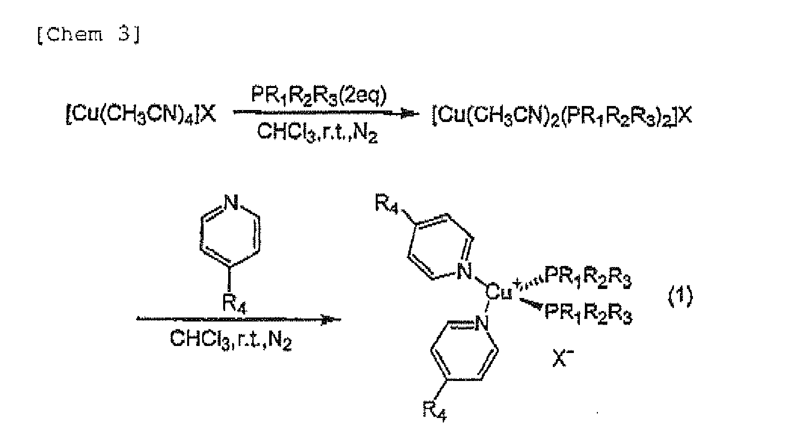

Specific examples of the copper complex represented by Formula (1) are shown below. X in the formula is as defined above.

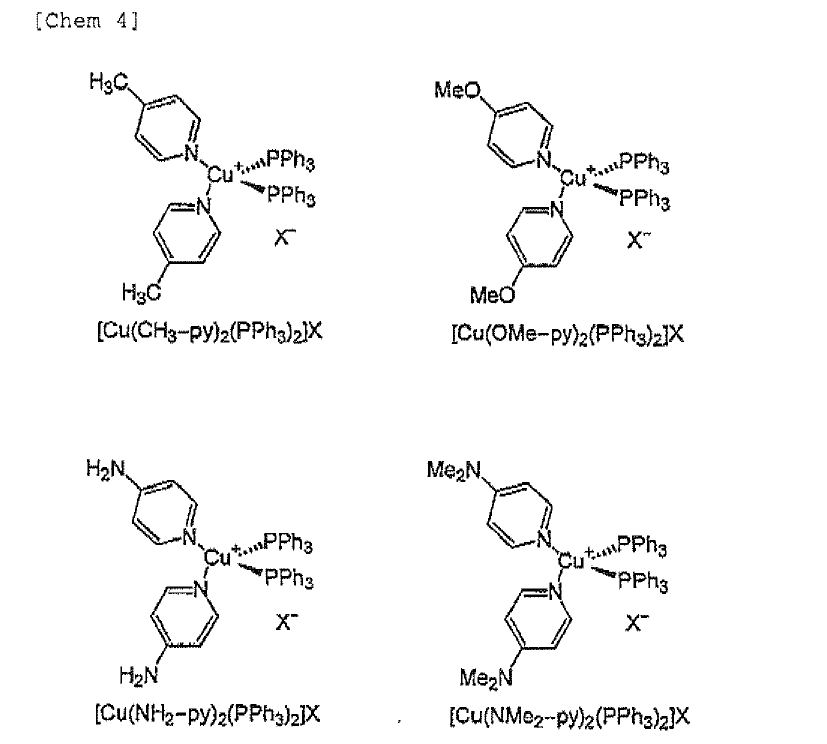

As the host material, a material having a high efficiency in energy transfer to the emitting dopant is preferably used. The host materials used when using a phosphorescent emitting dopant as the emitting dopant are roughly classified into a small-molecular type and a polymer type. An emissive layer containing a small-molecular host material is mainly formed by vacuum coevaporation of a small-molecular host material and an emitting dopant. An emissive layer containing a polymer host material is formed by applying a solution obtained by blending the polymer host material with the emitting dopant as essential components. Typical examples of the small-molecular host material include 1,3-bis(carbazole-9-yl)benzene (mCP). Typical examples of the polymer host material include poly(N-vinylcarbazole) (PVK). Besides the above materials, 4,4'-bis(9-dicarbazolyl)-2,2'-biphenyl (CBP), p-bis(triphenylsilyl)benzene (UGH2) and the like may be used as the host material in this embodiment.

In the case of using a host material having high hole-transport ability, the carrier balance between holes and electrons in the emissive layer is not maintained, giving rise to the problem concerning a drop in luminous efficacy. For this, the emissive layer may further contain an electron injection/transport material. In the case of using a host material having high electron-transport ability on the other hand, the emissive layer may further contain a hole injection/transport material. Such a structure ensures a good carrier balance between holes and electrons in the emissive layer, leading to improved luminous efficacy.

A method for forming the emissive layer 14 includes, for example, spin coating, but is not particularly limited thereto as long as it is a method which can form a thin film. A solution containing an emitting dopant and host material is applied in a desired thickness, followed by heating and drying with a hot plate and the like. The solution to be applied may be filtrated with a filter in advance.

The thickness of the emissive layer 14 is preferably 10-100 nm. The ratio of the host material and emitting dopant in the emissive layer 14 is arbitrary as long as the effect of the present invention is not impaired.

The substrate 11 is a member for supporting other members. The substrate 11 is preferably one which is not modified by heat or organic solvents. A material of the substrate 11 includes, for example, an inorganic material such as alkali-free glass and quartz glass; plastic such as polyethylene, polyethylene terephthalate (PET), polyethylene naghthalate (PEN), polyimide, polyamide, polyamide-imide, liquid crystal polymer, and cycloolefin polymer; polymer film; and metal substrate such as stainless steel (SUS) and silicon. In order to obtain light emission, a transparent substrate consisting of glass, synthesized resin, and the like is preferably used. Shape, structure, size, and the like of the substrate 11 are not particularly limited, and can be appropriately selected in accordance with application, purpose, and the like. The thickness of the substrate 11 is not particularly limited as long as it has sufficient strength for supporting other members.

The anode 12 is formed on the substrate 11. The anode 12 injects holes into the hole transport layer 13 or the emissive layer 14. A material of the anode 12 is not particularly limited as long as it exhibits conductivity. Generally, a transparent or semitransparent material having conductivity is deposited by vacuum evaporation, sputtering, ion plating, plating, and coating methods, and the like. For example, a metal oxide film and semitransparent metallic thin film exhibiting conductivity may be used as the anode 12. Specifically, a film prepared by using conductive glass consisting of indium oxide, zinc oxide, tin oxide, indium tin oxide (ITO) which is a complex thereof, fluorine doped tin oxide (FTO), indium zinc oxide, and the like (NESA etc.); gold; platinum; silver; copper; and the like are used. In particular, it is preferably a transparent electrode consisting of ITO. As an electrode material, organic conductive polymer such as polyaniline, the derivatives thereof, polythiophene, the derivatives thereof, and the like may be used. When ITO is used as the anode 12, the thickness thereof is preferably 30-300 nm. If the thickness is thinner than 30 nm, the conductivity is decreased and the resistance is increased, resulting in reducing the luminous efficiency. If it is thicker than 300 nm, ITO loses flexibility and is cracked when it is under stress. The anode 12 may be a single layer or stacked layers each composed of materials having various work functions.

The hole transport layer 13 is optionally arranged between the anode 12 and emissive layer 14. The hole transport layer 13 receives holes from the anode 12 and transports them to the emissive layer side. As a material of the hole transport layer 13, for example, polythiophene type polymer such as a conductive ink, poly(ethylenedioxythiophene): polystyrene sulfonate [hereinafter, referred to as PEDOT: PSS] can be used, but is not limited thereto. A method for forming the hole transport layer 13 is not particularly limited as long as it is a method which can form a thin film, and may be, for example, a spin coating method. After applying a solution of hole transport layer 13 in a desired film thickness, it is heated and dried with a hotplate and the like. The solution to be applied may be filtrated with a filter in advance.

The electron transport layer 15 is optionally formed on the emissive layer 14. The electron transport layer 15 receives electrons from the electron injection layer 16 and transports them to the emissive layer side. As a material of the electron transport layer 15 is, for example, tris[3-(3-pyridyl)-mesityl]borane [hereinafter, referred to as 3TPYMB], tris(8-hydroxyquinolinato)aluminum [hereinafter, referred to as Alq₃], and basophenanthroline (BPhen), but is not limited thereto. The electron transport layer 15 is formed by vacuum evaporation method, a coating method or the like.

The electron injection layer 16 is optionally formed on the electron transport layer 15. The electron injection layer 16 receives electrons from the cathode 17 and transports them to the electron transport layer 15 or emissive layer 14. A material of the electron injection layer 16 is, for example, CsF, LiF, and the like, but is not limited thereto. The electron injection layer 16 is formed by vacuum evaporation method, a coating method or the like.

The cathode 17 is forked on the emissive layer 14 (or the electron transport layer 15 or the electron injection layer 16). The cathode 17 injects electrons into the emissive layer 14 (or the electron transport layer 15 or the electron injection layer 16). Generally, a transparent or semitransparent material having conductivity is deposited by vacuum evaporation, spluttering, ion plating, plating, coating methods, and the like. Materials for the cathode include a metal oxide film and semitransparent metallic thin film exhibiting conductivity. When the anode 12 is formed with use of a material having high work function, a material having low work function is preferably used as the cathode 17. A material having low work function includes, for example, alkali metal and alkali earth metal. Specifically, it is Li, In, Al, Ca, Mg, Na, K, Yb, Cs, and the like.

The cathode 17 may be a single layer or stacked layers each composed of materials having various work functions. Further, it may be an alloy of two or more metals. Examples of the alloy include a lithium-aluminum alloy, lithium-magnesium alloy, lithium-indium alloy, magnesium-silver alloy, magnesium-indium alloy, magnesium-aluminum alloy, indium-silver alloy, and calcium-aluminum alloy.

The thickness of the cathode 17 is preferably 10-150 nm. When the thickness is thinner than the aforementioned range, the resistance is excessively high. When the film thickness is thicker, long period of time is required for deposition of the cathode 17, resulting in deterioration of the performance due to damage to the adjacent layers.

Explained above is an organic light-emitting diode in which an anode is formed on a substrate and a cathode is arranged on the opposite side to the substrate, but the substrate may be arranged on the cathode side.

FIG. 2 is a circuit diagram showing a display according to an embodiment.

A display 20 shown in FIG. 2 has a structure in which pixels 21 are arranged in circuits each provided with a lateral control line (CL) and vertical digit line (DL) which are arranged matrix-wise. The pixel 21 includes a light-emitting diode 25 and a thin-film transistor (TFT) 26 connected to the light-emitting diode 25. One terminal of the TFT 26 is connected to the control line and the other is connected to the digit line. The digit line is connected to a digit line driver 22. Further, the control line is connected to the control line driver 23. The digit line driver 22 and the control line driver 23 are controlled by a controller 24.

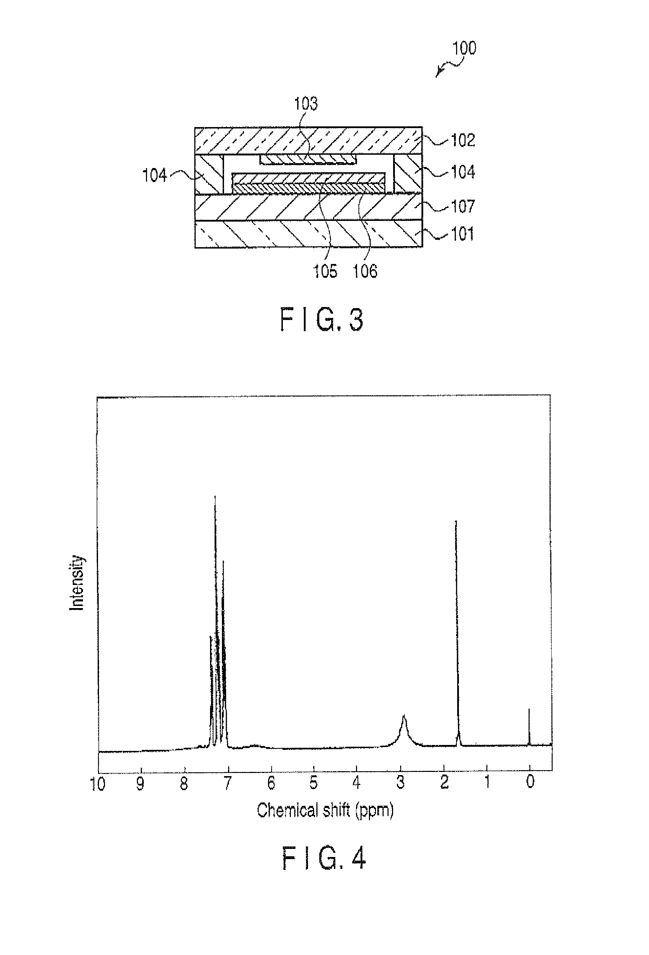

FIG. 3 is a cross-sectional view showing a lighting device according to an embodiment.

A lighting device 100 has a structure in which an anode 107, an organic light-emitting diode layer 106 and a cathode 105 are formed in this order on a glass substrate 101. A seal glass 102 is disposed so as to cover the cathode 105 and adhered using a UV adhesive 104. A drying agent 103 is disposed on the cathode 105 side of the seal glass 102.

### Examples

### Synthesis of [Cu(NMe₂-py)₂(PPh₃)₂]BF₄>

[Cu(NMe₂-py)₂(PPh₃)₂]BF₄ to be described herein is a copper complex in which: pyridine into which a dimethylamino group is introduced at position-4 (NMe₂-py) and triphenylphosphine (PPh₃) coordinates with copper ions; and a counter ion is BF₄⁻. A synthetic example of [Cu(NMe₂-py)₂(PPh₃)₂]BF₄ is described below.

### (Reaction I)

A 100 mL three-neck flask was charged with tetrakisacetonitrile copper (I) tetrafluoroborate (0.51 g, 1.62 mmol) and triphenylphosphine (0.85 g, 3.24 mmol), and the mixture in the flask was dried under vacuum. The atmosphere in the three-neck flask was flushed with nitrogen, and 25 mL of chloroform bubbled by nitrogen was added in the flask by using a syringe in which the atmosphere was purged with nitrogen, After the mixture was stirred at ambient temperature for 6 hours, the reaction solution was filtrated to remove insoluble materials. When hexane was added to the filtrate, a white solid was precipitated. The precipitate was isolated by filtration to obtain [Cu(CH₃CN)₂(PPh₃)₂]BF₄ which was a target product (yield: 97%).

The reaction scheme of the above Reaction I is shown below.

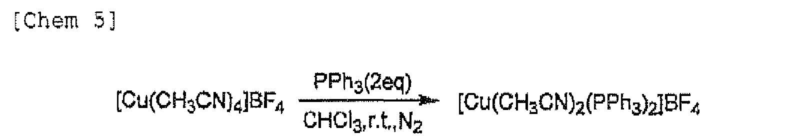

### (Reaction II)

A 50 mL three-neck flask was charged with [Cu(CH₃CN)₂(PPh₃)₂]BF₄ (48.4 mg, 0.064 mmol) and 4-dimethylaminopyridine (16.1 mg, 0.13 mmol), and the mixture in the flask was dried under vacuum. The atmosphere in the three-neck flask was flushed with nitrogen, and 5 mL of chloroform bubbled by nitrogen was added in the flask by using a syringe in which the atmosphere was purged with nitrogen. After the mixture was stirred at ambient temperature for 6 hours under a nitrogen atmosphere, the reaction solution was filtrated to remove insoluble materials. After distilling away the solvent of the filtrated, a white solid was obtained by drying under vacuum. The obtained white solid was recrystallized from chloroform/hexane to obtain [Cu(NMe₂-py)₂(PPh₃)₂]BF₄ which was a target product (yield: 86%).

The reaction scheme of the above Reaction II is shown below.

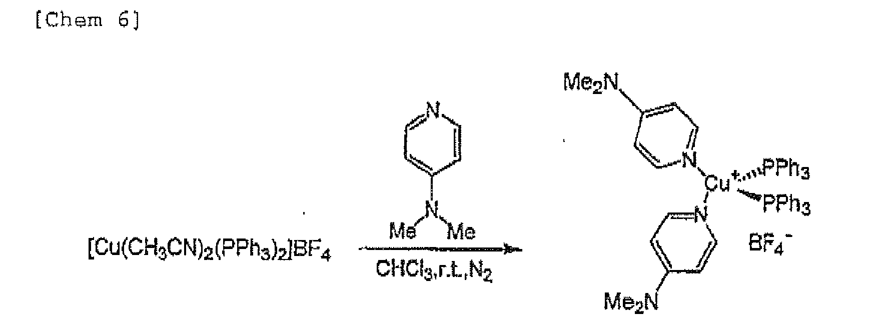

¹H-NMR spectrum (CDCl₃, 270 MHz) of [Cu(NMe₂-py)₂(PPh₃)₂]BF₄ synthesized by the above-described method is shown in FIG. 4.

### <Measurement of PL Spectrum>

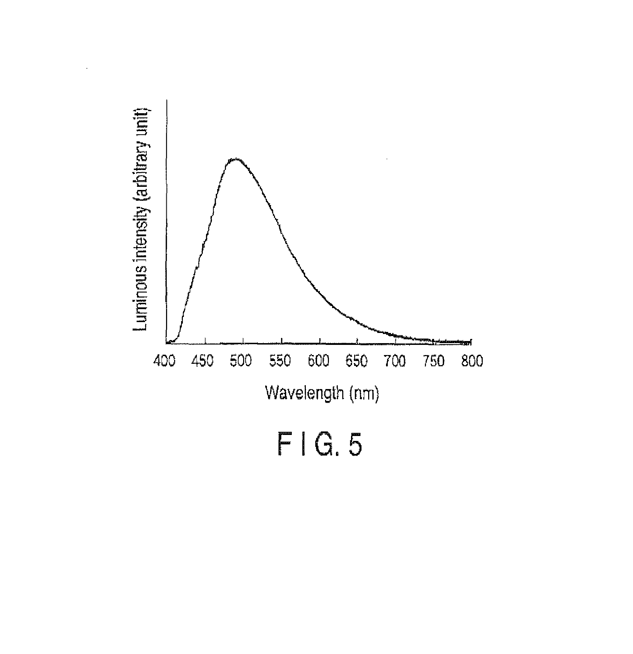

A photoluminescence (PL) spectrum of [Cu(NMe₂-py)₂(PPh₃)₂]BF₄ obtained by the above-described synthetic method was measured. The measurement was conducted at ambient temperature in a solid state by using a multi-channel detector PMA-11 manufactured by Hamamatsu Photonics K.K. The results are shown in FIG. 5. As a result of excitation with ultraviolet light having an excitation, wavelength of 365 nm, light blue emission having an emission peak of 490 nm was exhibited.

### <Fabrication of Organic Light-Emitting Diode>

The above synthesized [Cu(NMe₂-py)₂(PPh₃)₂]BF₄ was used as an emitting dopant to fabricate an organic light-emitting diode. The layer structure of this diode is as follows: ITO 100 nm/PEDOT:PSS 45 nm/PVK: OXD-7: [Cu(NMe₂-py)₂(PPh₃)₂]BF₄ 70 nm/3TPYMB 25 nm/CsF 1 nm/Al 150 nm.

The anode was a transparent electrode made of ITO (indium-tin oxide) 100 nm in thickness.

As the material of the hole-transport layer, an aqueous poly(ethylenedioxythiophene):poly(styrene·sulfonic acid) [PEDOT:PSS] solution which is conductive ink was used. An aqueous PEDOT:PSS solution was applied by spin coating, and dried under heating to form a hole-transport layer 45 nm in thickness.

As to the materials used for the emissive layer, poly(N-vinylcarbazole) [PVK] was used as the host material, 1,3-bis(2-(4-tertiarybutylphenyl)-1,3,4-oxydiazole-5-yl)benzene[OXD-7] was used as the electron-transport material and [Cu(NMe₂-py)₂(PPh₃)₂]BF₄ was used as the emitting dopant. PVK is a hole-transport host material and OXD-7 is an electron-transport material. Therefore, if a mixture of these materials is used as the host material, electrons and holes can be efficiently injected into the emissive layer when voltage is applied. These compounds were weighed such that the ratio by weight of these compounds is as follows: PVK : OXD-7: [Cu(NMe₂-py)₂(PPh₃)₂]BF₄ = 60 : 30 : 10, and dissolved in chlorobenzene to obtain a solution, which was applied by spin coating, followed by drying under heating to form an emissive layer 70 nm in thickness.

The electron-transport layer was formed in a thickness of 50 nm by vapor evaporation of tris[3-(3-pyridyl)-mesityl]borane [3TPYMB]. The electron injection layer was formed of CsF 1 nm in thickness and the cathode was formed of Al 150 nm in thickness.

### <Luminous Characteristics of Organic Light-Emitting Diode>

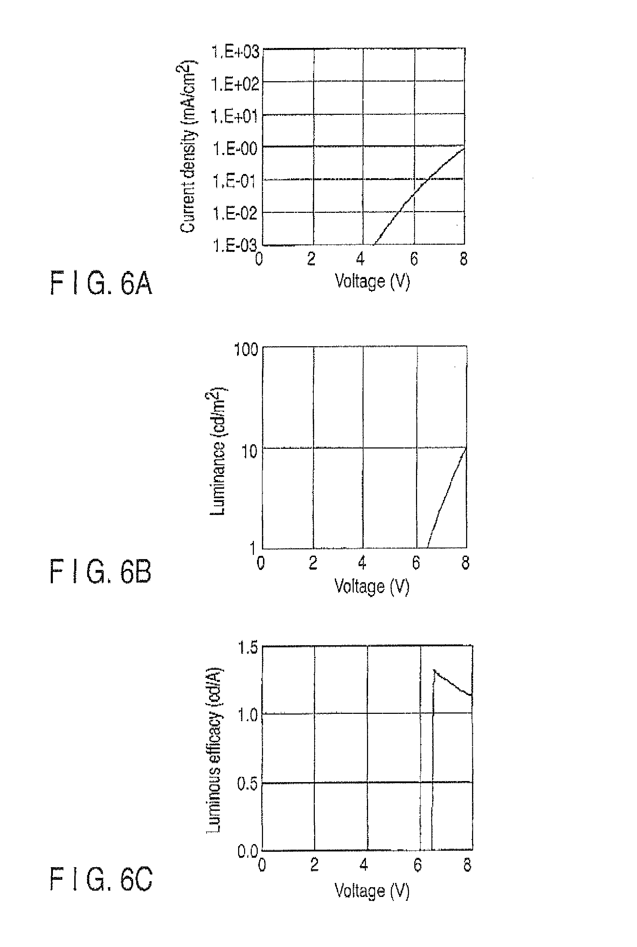

The luminous characteristics of the organic light-emitting diode fabricated in the above manner were examined. FIG. 6A is a view showing the relationship between the voltage and current density of the diode according to Example. FIG. 6B is a view showing the relationship between the voltage and luminance of the diode according to Example. FIG. 6C is a view showing the relationship between the voltage and luminous efficacy of the diode according to Example. The luminous efficacy was obtained by simultaneous measurement of luminance, current and voltage. The luminance was measured using a Si Photodiode S7610 (trade name, manufactured by Hamamatsu Photonics K.K.) with a visibility filter. Further, the current and the voltage were measured using a Semiconductor Parameter Analyzer 4156b (trade name, manufactured by Hewlett Packard).

Current density rose along with application of voltage and the light-emitting was started at 6.5 V. The luminance was 10 cd/cm² at 8 V and the maximum luminous efficacy was 1.3 cd/A.

### <Estimation of Emission Wavelength by Molecular Orbital Calculation>

An emission wavelength of each of [Cu(py)₂(PPh₃)₂]⁺ which is a copper complex which does not have any substituent in a pyridine ring, [Cu(CH₃-py)₂(PPh₃)₂]⁺, [Cu(OMe-py)₂(PPh₃)₂]⁺, [Cu(NH₂-py)₂(PPh₃)₂]⁺ and [Cu(NMe₂-py)₂(PPh₃)₂]⁺ which are copper complexes in which an electron-donating substituent is introduced into a pyridine ring, was estimated by a molecular orbital calculation. Structures of [Cu(py)₂(PPh₃)₂]⁺, [Cu(CH₃-py)₂(PPh₃)₂]⁺, [Cu(OMe-py)₂(PPh₃)₂]⁺, [Cu(NH₂-py)₂(PPh₃)₂]⁺ and [Cu(NMe₂-py)₂(PPh₃)₂]⁺ are shown below.

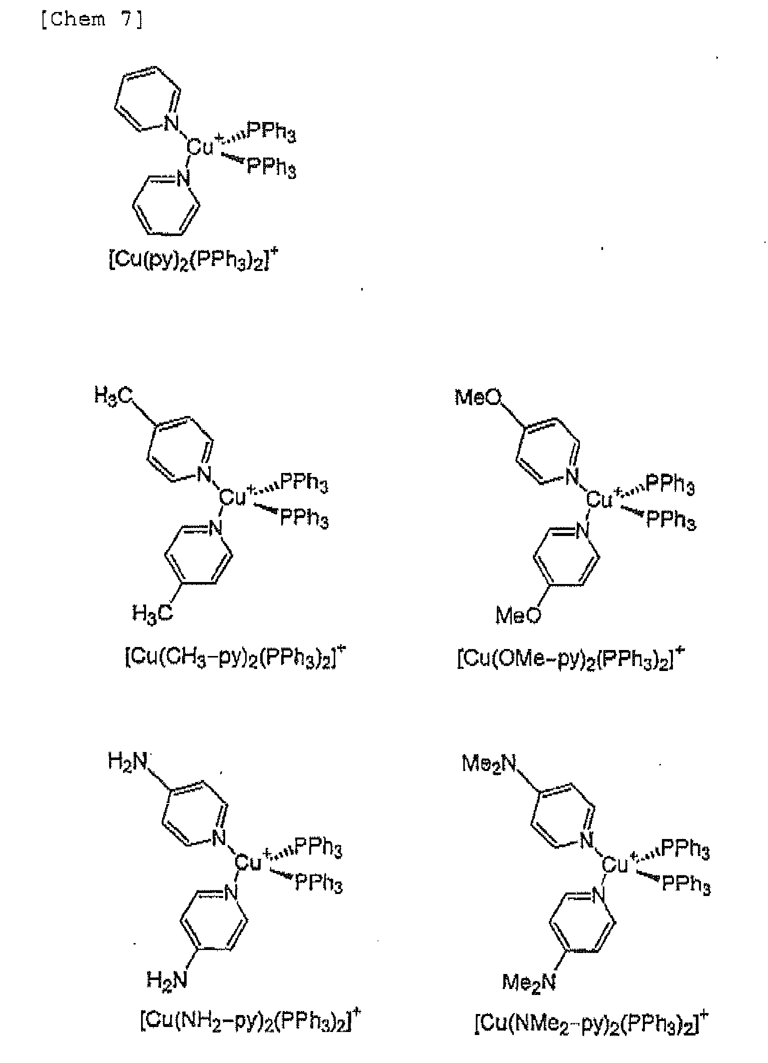

The calculation was performed by using Gaussian03 which is molecular orbital calculation software. A structure optimization was performed by employing a density functional Theory (DFT), and the emission wavelength was estimated by applying a time-dependent density functional Theory (TD-DFT) to the optimum structure. As a base function, LanL2Dz was used for Cu, and 6-31G* was used for C, H, N, P and O.

As a result, the emission wavelengths were 353.9 nm ([Cu(py)₂(PPh₃)₂]⁺), 346.6 nm ([Cu(CH₃-py)₂(PPh₃)₂]⁺), 346.3 nm ([Cu(OMe-py)₂(PPh₃)₂]⁺), 347.0 nm ([Cu(NH₂-py)₂(PPh₃)₂]⁺) and 347.6 nm ([Cu(NMe₂-py)₂(PPh₃)₂]⁺). It was expected by the molecular orbital calculation that the copper complex in which the electron-donating substituent was introduced into the pyridine ring has a shorter emission wavelength by about 7 nm as compared to the copper complex [Cu(py)₂(PPh₃)₂]⁺ which did not have any substituent in the pyridine ring.

According to the embodiment or the examples, it is possible to provide the copper complex which is inexpensive, easily synthesized and has the emission wavelength which is the short wavelength and the organic light-emitting diode, the display device and the lighting device using the copper complex as the emitting dopant.

While certain embodiments have been described, these embodiments have been presented by way of example only, and are not intended to limit the scope of the inventions. Indeed, the novel embodiments described herein may be embodied in a variety of other forms; furthermore, various omissions, substitutions and changes in the form of the embodiments described herein may be made without departing from the spirit of the inventions. The accompanying claims and their equivalents are intended to cover such forms or modifications as would fall within the scope and spirit of the inventions.

## Claims

1. A compound represented by Formula (1) : 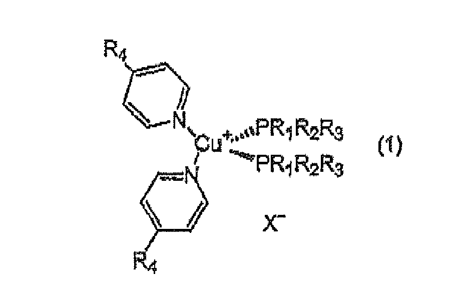 where Cu⁺ represents a copper ion, PR₁R₂R₃ represents a phosphine compound coordinating with Cu⁺, where R₁, R₂ and R₃ may be the same or different, and represent a linear, branched or cyclic alkyl group having 1-6 carbon atoms or an aromatic cyclic group which may have a substituent, R₄ represents an electron-donating substituent, and X⁻ represents a counter ion where X is at least one selected from the group consisting of F, Cl, Br, I, BF₄, PF₆, CH₃CO₂, CF₃CO₂, CF₃SO₃ and ClO_{4.}

2. The compound according to Claim 1, **characterized in that**
each of R₁, R₂ and R₃ represents a phenyl group, R₄ is selected from the group consisting of amino groups methyl group, dimethylamino group and methoxy group, and
X represents BF₄.

3. An organic light-emitting diode **characterized by** comprising:
an anode (12) and a cathode (13) which are arranged apart from each other; and
an emissive layer (14) interposed between the anode (12) and the cathode (13) and comprising a host material and an emitting dopant, the emitting dopant comprising the compound according to Claim 1.

4. The organic light-emitting diode according to Claim 3, **characterized in that** the host material is a small-molecular material or a polymer material.

5. A display **characterized by** comprising the organic light-emitting diode according to Claim 3.

6. A lighting device **characterized by** comprising the organic light-emitting diode according to Claim 3.
